# EUROPÄISCHE PATENTSCHRIFT

(11) **EP 3 759 505 B1**
(45) Veröffentlichungstag und Bekanntmachung des Hinweises auf die Patenterteilung: **11.10.2023**
(21) Anmeldenummer: 19702594.3
(22) Anmeldetag: 31.01.2019
(51) Int. Cl.: G01R 19/25

(54) **VERFAHREN ZUR BEWERTUNG DES ZUSTANDES UND DER QUALITÄT VON NIEDERSPANNUNGSNETZEN**
METHOD FOR EVALUATING THE STATE AND THE QUALITY OF LOW-VOLTAGE NETWORKS
PROCÉDÉ D'ÉVALUATION DE L'ÉTAT ET DE LA QUALITÉ DE RÉSEAUX BASSE TENSION

(30) Priorität: 27.02.2018 DE 102018104462; 13.06.2018 DE 102018114181
(43) Veröffentlichungstag der Anmeldung: 06.01.2021
(73) Patentinhaber: DEHN SE, 92318 Neumarkt i.d. OPf. (DE)
(72) Erfinder: EHRLER, Jens, 92318 Neumarkt (DE); ZAHLMANN, Peter, 92318 Neumarkt (DE); BROCKE, Ralph, 98693 Ilmenau/Oberpörlitz (DE)
(74) Vertreter: Prinz & Partner mbB
(86) Internationale Anmeldenummer: PCT/EP2019/052306
(87) Internationale Veröffentlichungsnummer: WO 2019/166174

(56) Entgegenhaltungen:
- EP-B1- 2 478 607
- WO-A1-2013/132292
- WO-A1-2016/091239
- DE-A1-102013 018 482
- DE-A1-102014 219 913
- KR-B1- 101 755 560
- US-A1- 2010 070 213
- US-A1- 2010 142 601

## Beschreibung

Die Erfindung geht aus von einem Verfahren zur Bewertung des Zustandes und der Qualität von Niederspannungsnetzen, in dessen verzweigten System sich eine Vielzahl von angeschlossenen Verbrauchern befindet, durch Ermittlung von Netzmessdaten mittels Power-Quality-Mess-und Prüfeinrichtungen sowie Übertragung der Netzmessdaten mittels Schnittstelle an ein Leitsystem oder in abrufbarer Form zu einem Server gemäß Oberbegriff des Anspruches.

Aus der DE 10 2006 034 164 B4 ist ein mehrpoliger Blitzstrom- und/oder Überspannungsableiter in Reihenklemmausführung vorbekannt. Dieser Überspannungsableiter dient bevorzugt zum Schutz von Geräten und Anlagen der Informationstechnik und besteht aus Basisteil, ausgebildet als Durchgangsklemme, und in das Basisteil einsetzbarer Steckmodule mit Schutzelementen zur Hutschienenmontage.

Gemäß einer dortigen Ausführungsform ist eine Leiterplatte vorgesehen, welche eine Einrichtung zur drahtlosen Fehler- und Zustandsüberwachung, zum Beispiel in Form eines RFID-Transponders aufweist. Die Leiterplatte kann auch Mittel zur Temperaturüberwachung der auf den übrigen Leiterplatten befindlichen Schutzelemente enthalten. Solche Mittel können Temperatursensoren sein, die jeweils nahe, insbesondere gegenüberliegend der Schutzelemente befindlich sind.

Insofern besitzt also der oben geschilderte, bekannte Überspannungsableiter eine Eigendiagnoseeinheit.

Bei dem Smart-Meter gemäß DE 20 2012 010 818 U1 weist dieses eine Elektronik zur Erfassung des Stromverbrauches und zur Ausgabe von den Stromverbrauch repräsentierenden Daten über eine Datenkommunikationsschnittstelle auf.

Gemäß einer bevorzugten Ausführungsform ist eine LAN-Schnittstelle zum Auslesen und Programmieren des Smart-Meters vorgesehen, während wenigstens eine weitere Schnittstelle und die Elektronik des Smart-Meters dazu eingerichtet sind, zur Steuerung sonstiger externer Geräte zu dienen, die dann zum Beispiel über ein Feldbussystem von dem ebenfalls an das Feldbussystem angeschlossenen Smart-Meter gesteuert werden können.

Ebenso besteht die Möglichkeit, in das Gehäuse des Smart-Meters einen Webserver zu integrieren, so dass der von dem Smart-Meter ermittelte Stromverbrauch von externen Geräten, zum Beispiel auch von Mobiltelefonen, über eine geeignete Software über das Internet abgefragt werden kann.

Die Überspannungsschutzvorrichtung mit Überwachungsfunktion nach DE 10 2014 219 913 A1 besitzt eine spezielle Schaltungsanordnung nach Art einer Wheatstone'schen Messbrücke, um den Zustand der dort vorhandenen Überspannungsschutzelemente zeitlich unmittelbar zu erkennen.

Zur Zustandskontrolle können alternativ oder zusätzlich temporäre, aber auch periodisch wiederkehrende Messungen vorgenommen werden.

Eine lokale Signalisierung des Zustandes kann beispielsweise durch ein optisches und/oder akustisches Signal oder ein Display erfolgen. Eine Fernsignalisierung kann durch eine Fernmeldung, zum Beispiel über einen Automatisierungsbus oder allgemein mittels Telekommunikation, realisiert werden.

Aus der WO 2016/091239 A1 ist eine Mess- und/oder Prüfvorrichtung sowie ein Verfahren zur Messung und/oder Einschätzung der Qualität oder der Stabilität von Stromnetzen vorbekannt. In dieser Druckschrift wird herausgestellt, dass aufgrund neuer, verteilter Erzeugereinheiten zur Bereitstellung elektrischer Energie in vielen Fällen aufgrund fehlender Messgeräte zur Erfassung der Spannungsqualität Netzstörungen auftreten. Ein dezentral gespeistes Netz benötigt ein Mindestmaß an ebenfalls dezentralen Mess- und Regeleinrichtungen, um das Netz stabil und effizient betreiben zu können sowie um Störungen der Versorgungsqualität (Power Quality) in Endverbraucherhaushalten zu erkennen und zu beheben. Diesbezüglich schlägt die WO 2016/091239 A1 eine Mess- und/oder Prüfvorrichtung vor, die mit Netzabgreifmitteln und Netzteil ausgeführt ist, welche mit einer Einheit mit wenigstens einer AD-Wandlerschaltung zur kontinuierlichen Abtastung, Digitalisierung und Weitergabe von wenigstens Spannungs- und/oder Frequenzwerten der Netzspannung über eine Schnittstelle ausgerüstet ist. Eine Mikrocontrollereinheit dient der Aufbereitung und/oder Wandlung der Daten und steht mit der Mess- und/oder Prüfvorrichtung in Verbindung.

Verfahrensseitig erfolgt nun eine Bestimmung von Netzmessdaten, eine Weitergabe der Messdaten über eine erste, lokale Datenverbindung einer internen Mikrocontrollereinheit oder ein IT-Gerät, ein Verarbeiten und/oder Bearbeiten aber auch ein Bewerten der Daten in der Mikrocontrollereinheit und/oder dem IT-Gerät sowie ein Versehen der Daten mit Zeitstempel und Ortskennzeichnung. Im Anschluss werden die Daten über eine zweite Datenverbindung einem Rechenzentrum und/oder ein weiteres IT-Gerät und/oder ein Speichermedium weitergegeben. Im Rechenzentrum oder beim Energieversorger kann dann eine Bewertung der Daten vorgenommen werden und gegebenenfalls ein Eingriff in das Netz erfolgen.

Bei der EP 2 478 607 B1 wird ein Verfahren zur Überwachung eines elektrischen Energieversorgungsnetzes vorgeschlagen, bei dem an mindestens zwei unterschiedlichen Messstellen in dem Energieversorgungsnetz eine den Zustand des elektrischen Energieversorgungsnetz charakterisierende Erfassung von Messwerten vorgenommen wird. Jedem Messwert wird ein den Zeitpunkt seiner Erfassung angebender Zeitstempel zugeordnet. Darüber hinaus wird eine Schwellenwertbetrachtung anhand eines Referenzwertes vorgenommen. Ebenfalls erfolgt eine statistische Auswertung und Übergabe der Daten an eine Leitstelleneinrichtung des Energieversorgungsnetzes.

Die DE 10 2013 018 482 A1 zeigt ein Verfahren und eine Vorrichtung zur automatischen Charakterisierung und Überwachung eines elektrischen Netzes oder eines Stromnetzabschnittes eines elektrischen Netzes bzw. einer elektrischen Anlage. Ziel der dortigen Lehre ist es, bereits im Vorfeld Entscheidungen zur Vermeidung von Störfällen treffen zu können und/oder erforderliche Schaltvorgänge oder andere Gegenmaßnahmen automatisch auszuführen.

Diesbezüglich erfolgt der Aufbau eines Netzwerte-, Mess- und Überwachungssystems sowie eine mathematische Bewertung einer Vielzahl der einleitenden Messwerte, um hiernach anhand von Erfahrungswerten die netzqualitätssichernden Maßnahmen einzuleiten.

Bei dem Datengewinnungsverfahren zur Qualitätsbewertung von Elektroenergie nach DE 10 2004 022 719 B4 soll ebenfalls eine vorausschauende Erkennung und schnelle Beseitigung von Qualitätsstörungen erreicht werden. Anhand der Information des Netzes werden mittels Spannungs- und Stromwandlern zum Erfassen momentaner Ströme und Spannungen Werte an bestimmten Erfassungspunkten ermittelt und mittels A/D-Wandler digitalisiert.

Anhand relevanter, qualitätsbestimmender Kennwerte wird ein mathematisch determinierter Vergleich einlaufender Messdaten mit Kenn- oder Normwerten vorgenommen, um hieraus die Netzqualität zu definieren.

Bekannt sind weiterhin Netzqualitätsmessgeräte, auch ausgeführt zur Hutschienenmontage. Beispielsweise sei hier das Gerät UMD 705 der Firma Helvatron genannt (siehe www.helvatron.com/de/power-quality/umd-705).

Zusammenfassend ist es aus dem Stand der Technik bekannt, mittels bereits am Markt erhältlicher Mess- und Prüftechnik die Qualität eines Niederspannungsnetzes zu überprüfen, die gesammelten Daten aufzubereiten und über ein Leitsystem dem Energieversorger bereitzustellen. Entsprechende Mess- und Prüfeinrichtungen müssen jedoch in sehr aufwändiger Weise an möglichst vielen Stellen des Netzes integriert und dort elektrisch angeschlossen werden. Weiterhin müssen Möglichkeiten zur Datenübertragung von derartigen Mess- und Prüfeinrichtungen zum Leitsystem geschaffen werden. All die vorgenannten Maßnahmen sind jedoch mit einem erheblichen Aufwand und zusätzlichen Kosten verbunden.

Aus dem Vorgenannten ist es daher Aufgabe der Erfindung, ein weiterentwickeltes Verfahren zur Bewertung des Zustandes und der Qualität von Niederspannungsnetzen, in denen sich eine Vielzahl von angeschlossenen Verbrauchern befindet, anzugeben, bei denen Netzmessdaten ermittelt werden und hierbei auf an sich bekannte Power-Quality-Mess-und Prüfeinrichtungen zurückgegriffen wird.

Die Lösung der Aufgabe der Erfindung erfolgt durch die Lehre des Anspruches 1, wobei die Unteransprüche mindestens zweckmäßige Ausgestaltungen und Weiterbildungen darstellen.

Demnach werden in erfindungsgemäßer Weise die im Niederspannungssystem eingesetzten und bereits vorhandenen oder einsetzbaren Überspannungsschutzeinrichtungen, die über eine Eigendiagnoseeinheit und eine drahtlose oder drahtgebundene Standard-Schnittstelle verfügen, mittels integrierter oder adaptierter Power-Quality-Mess-und Prüfungseinrichtungen zur Ermittlung von Netzmessdaten ertüchtigt.

Durch den bereits bestimmungsgemäßen vielfältigen Einsatz derartig ertüchtigter Überspannungsschutzeinrichtungen an unterschiedlichsten Stellen des Niederspannungsnetzes ist eine Netzzustands-Landkarte erstellbar. Die sich hieraus orts- und zeitbezogen ergebenden Netzzustandsdaten werden, vom Netzbetreiber abrufbar, bereitgestellt. Bereits heute ist davon auszugehen, dass mindestens in jedem Gebäude eine Überspannungsschutzeinrichtung vorhanden ist. Betrachtet man ein gesamtes Niederspannungssystem, dann ist von einer Vielzahl von Überspannungsableitern auszugehen, die das Netz quasi schwarmartig durchdringen. Mit Ertüchtigung dieser bereits vorhandenen oder noch einzusetzenden Überspannungsschutzeinrichtungen zur Ermittlung von Netzmessdaten liegt eine neue Qualität der Durchdringung oder Durchsetzung des Netzes vor, so dass nicht nur die Netzqualität beurteilt werden kann, sondern die Möglichkeit besteht, den Schutzpegel der Überspannungsschutzeinrichtungen anzupassen, zum Beispiel bei auftretenden Schalthandlungen im Netz. Dabei besteht die Möglichkeit, das Niederspannungssystem in einzelne Unternetze zergliedert zu betrachten und zum Beispiel bei einem Netz in einer Industrieumgebung Daten für den Netzbetreiber zu gewinnen, die diesen veranlassen können, die Versorgung und Vergütung in einer solchen Industrieumgebung im Vergleich zu Netzsystemen in reinen Wohngebieten zu differenzieren. Eine derartige Analyse von Netzsystemen gewinnt insbesondere Bedeutung durch die Zunahme der Anzahl und den Einsatz von Elektrofahrzeugen, die regelmäßig netzbetriebene Ladestationen anfahren müssen.

Im erfindungsgemäßen Sinne werden also die bei Überspannungsschutzeinrichtungen vorhandenen Möglichkeiten zur drahtlosen oder drahtgebundenen Datenübertragung genutzt, um neben zum Beispiel Eigendiagnosedaten der Überspannungsschutzeinrichtungen die erwähnten Power-Quality-Mess-und Prüfdaten, die mit entsprechenden Einrichtungen gewonnen werden, zur Zustandsanalyse bereitzustellen.

In erfindungsgemäßer Weise sind die bevorzugt eingesetzten Überspannungsschutzeinrichtungen bereits mit einer Power-Quality-Mess-und Prüfeinrichtung versehen. Manuell oder über einen Datenbefehl wird die im Überspannungsableiter integrierte Funktion zur Netzqualitätsbestimmung freigegeben oder abgerufen.

Wenn beispielsweise innerhalb der Netzzustands-Landkarte sich in einem bekannten lokalen Bereich Anzeichen schlechter Netzqualität häufen, kann durch Zuschaltung weiterer, bisher nicht aktivierter Überspannungsschutzeinrichtungen mit integrierter Power-Quality-Mess-und Prüfeinrichtung die örtliche Auflösung erhöht und festgestellt werden, welcher angeschlossene Verbraucher momentan Ursache für Netzstörungen ist. Hierbei kann es sich zum Beispiel um Spannungseinbrüche, verstärkte Oberwellenbildung, unerwünschte Phasenverschiebung oder dergleichen handeln.

In diesem Sinne umfasst die Netzzustands-Landkarte Angaben zum Oberwellenspektrum, wobei aus den ermittelten Oberwellenspektren Daten zur Anpassung parametrierbarer Filter abgeleitet werden.

Diese Anpassung vorhandener parametrierbarer Filter erfolgt durch bidirektionale Datenübertragung und entsprechend bidirektional ausgeführte Standard-Schnittstellen zeitnah, so dass Netzeinbrüche oder Netzausfälle vermeidbar sind.

Letztendlich kann aus der Netzzustands-Landkarte, die orts- und zeitbezogene Daten umfasst, eine statistische Auswertung und eine Langzeitbetrachtung des oder der jeweils überwachten Netze erfolgen, um Maßnahmen zur gleichmäßigen Netzauslastung abzuleiten und diese den Verbrauchern aber auch den Netzbetreibern zur Verfügung zu stellen, so dass letztendlich die Möglichkeit besteht, ein Preismodell für Energieversorger zu erarbeiten, dass dynamisch und im Sinne der Optimierung der Netzqualität strukturiert ist.

Mindestens ein Teil der verbrauchernahen Überspannungsschutzeinrichtungen sind parametrierbar bzw. werden mit aktiven, parametrierbaren Filtern versehen, so dass sich im Niederspannungsnetz ein verteiltes Filtersystem ergibt. Diesem verteilten Filtersystem werden Informationen über das jeweilige Oberwellenspektrum zugeführt, um im Anschluss durch Anpassung der dezentralen Filter die Netzqualität zu verbessern.

Wie bereits erwähnt, erfolgt die Datenübertragung bevorzugt bidirektional, so dass ausgehend von Daten der jeweils aktuellen Netzzustands-Landkarte Eigenschaften der Überspannungsschutzeinrichtungen zum Schutzbedürfnis, wie Ansprechspannung, Einstellwerte für die Überstromschutzfunktion, Kurzschlussströme im Netz und ähnliches dynamisch parametrierbar sind.

Die Daten der Netzzustands-Landkarte werden beispielsweise über ein Internetportal zur Verfügung gestellt und können mit Hilfe einer Applikationssoftware abgerufen werden.

Die erfindungsgemäße Lehre zielt darauf, Informationen, die nicht mit der originären Funktion von Überspannungsschutzeinrichtungen verbunden sind, zu ermitteln, und diese über eine Standard-Schnittstelle an ein übergeordnetes Leitsystem oder auf eine Anwender-Applikationssoftware zu übertragen. Diese besonderen Informationen beziehen sich auf netztypische Eigenschaften, wie Oberwellen, Spannungseinbrüche oder dergleichen, die von Power-Quality-Modulen ableitbar sind. Derartige Power-Quality-Module werden in die Überspannungsschutzeinrichtungen integriert oder können in einfacher Weise als Adapteranordnung auf ein Überspannungsschutzgerät aufgesteckt und mit diesem elektrisch verbunden werden.

Ein Vorteil der so umgesetzten Funktionsintegration besteht darin, dass es nicht notwendig ist, separate Geräte zu installieren und einen zusätzlichen Kommunikationskanal zu schaffen.

Ein besonderer Vorteil des erfindungsgemäßen Verfahrens liegt darin, dass ausgehend von der Grundfunktion von Überspannungsschutzgeräten diese an einer Vielzahl von Stellen im Netz vorhanden und damit im Netz verteilt sind. Beispielsweise sind Überspannungsschutzgeräte auch in der Einspeisehauptverteilung eingesetzt und können an dieser Stelle Informationen zur Netzqualität im gesamten nachgeschalteten System ermitteln.

Das erfindungsgemäße Verfahren schafft auch die Möglichkeit der Kommunikation verschiedener, derart ertüchtigter Überspannungsschutzgeräte. So kann als Konsequenz aus einem ermittelten Oberwellenspektrum eine Anpassung von aktiven Filtern vorgenommen werden, zum Beispiel bezogen auf einen angeschlossenen Verbraucher. Hierdurch kann das Oberwellenspektrum im gesamten Niederspannungssystem positiv beeinflusst werden. Dadurch, dass die Möglichkeit besteht, parametrierbare Filter durch dezentrale Anordnung die Überspannungsschutzgeräte ebenfalls zu dezentralisieren, ergibt sich eine vorteilhafte Alternative zur ansonsten üblichen Installation zentraler Filtereinheiten. Anordnungen mit verteilten Filtern in einem Netzsystem können schneller reagieren und sind auch kostenseitig vorteilhafter im Vergleich zu einer zentralen Einheit.

## Patentansprüche

1. Verfahren zur Bewertung des Zustandes und der Qualität von Niederspannungsnetzen, in dessen verzweigten System sich eine Vielzahl von angeschlossenen Verbrauchern befindet, durch Ermittlung von Netzmessdaten mittels Power-Quality-Mess-und Prüfeinrichtungen sowie Übertragung der Netzmessdaten mittels Schnittstelle an ein Leitsystem oder in abrufbarer Form zu einem Server,
**dadurch gekennzeichnet, dass**
die im Niederspannungssystem eingesetzten oder einsetzbaren Überspannungsschutzeinrichtungen mit Eigendiagnoseeinheit und vorhandener drahtloser oder drahtgebundener Standard-Schnittstelle zur Datenübermittlung mittels integrierter oder adaptierter Power-Quality-Mess-und Prüfeinrichtungen zur Ermittlung von Netzmessdaten ertüchtigt werden, wobei durch den bestimmungsgemäßen vielseitigen flächendeckenden Einsatz derartiger ertüchtigter Überspannungsschutzeinrichtungen an unterschiedlichsten Stellen des Niederspannungsnetzes eine Netzzustands-Landkarte erstellt und die sich hieraus orts- und zeitbezogen ergebenden Netzzustandsdaten, vom Netzbetreiber oder Versorger abrufbar, bereitgehalten werden.

2. Verfahren nach Anspruch 1,
**dadurch gekennzeichnet, dass**
die Netzzustands-Landkarte Angaben zum Oberwellenspektrum umfasst, wobei aus den ermittelten Oberwellenspektren Daten zur Anpassung parametrierbarer Filter abgeleitet werden.

3. Verfahren nach Anspruch 2,
**dadurch gekennzeichnet, dass**
mindestens ein Teil der verbrauchernahen Überspannungsschutzeinrichtungen mit aktiven, parametrierbaren Filtern versehen werden, so dass sich im Niederspannungsnetz ein verteiltes Filtersystem ergibt, welchem Informationen über das jeweilige Oberwellenspektrum zugeführt werden, um im Anschluss durch Anpassung der dezentralen Filter die Netzqualität zu verbessern.

4. Verfahren nach einem der vorangegangenen Ansprüche,
**dadurch gekennzeichnet, dass**
die Datenübermittlung bidirektional erfolgt, so dass ausgehend von Daten der jeweils aktuellen Netzzustands-Landkarte Eigenschaften der Überspannungsschutzeinrichtung zum Schutzbedürfnis, wie Ansprechspannung, Einstellwerte für die Überstromschutzfunktion, Kurzschlussströme im Netz und ähnliches dynamisch parametrierbar sind.

5. Verfahren nach einem der vorangehenden Ansprüche,
**dadurch gekennzeichnet, dass**
die Daten der Netzzustands-Landkarte mittels zur Verfügungstellung auf einem Internetportal und einer Applikationssoftware in laufend aktualisierter Weise abrufbar bereitgehalten werden.

## Claims

1. A method for evaluating the state and the quality of low-voltage networks, in the branched system of which a plurality of connected loads is located, by determining network measurement data by means of power quality measuring and testing devices and transferring the network measurement data by means of an interface to a control system or in retrievable form to a server,
**characterized in that**
the overvoltage protection devices employed or employable in the low-voltage system, which have a self-diagnosis unit and an existing wireless or wired standard interface for data transmission are upgraded by means of integrated or adapted power quality measuring and testing devices for determining network measurement data, wherein due to the intended versatile comprehensive employment of such upgraded overvoltage protection devices at the most different points of the low-voltage network, a network state map is established, and the network state data resulting therefrom in a location and time relation are kept available and can be retrieved by the network operator or supplier.

2. The method according to claim 1,
**characterized in that**
the network state map comprises indications as to the harmonic wave spectrum, wherein data items for adapting parameterizable filters are derived from the determined harmonic wave spectra.

3. The method according to claim 2,
**characterized in that**
at least part of the overvoltage protection devices close to the consumer are provided with active parameterizable filters, so that a distributed filter system results in the low-voltage network, which distributed filter system is fed with information about the respective harmonic wave spectrum, in order to subsequently improve the network quality by adapting the decentralized filters.

4. The method according to any one of the preceding claims,
**characterized in that**
the data transmission is performed bidirectionally, so that by starting from data of the respectively current network state map, properties of the overvoltage protection devices relative to the need of protection such as response voltage, set values for the overcurrent protection function, short-circuit currents in the network and similar are dynamically parameterizable.

5. The method according to any one of the preceding claims,
**characterized in that**
the data items of the network state map are held ready by being made available on an Internet portal and an application software in a continuously updated manner and so as to be retrievable.

## Revendications

1. Procédé d'évaluation de l'état et de la qualité de réseaux basse tension dans le système ramifié desquels se trouve une pluralité de consommateurs connectés, par la détermination de données de mesure de réseau au moyen de dispositifs de mesure et de contrôle de qualité d'énergie et par la transmission des données de mesure de réseau à un système de gestion au moyen d'une interface ou à un serveur sous forme interrogeable,
**caractérisé en ce que**
les dispositifs de protection contre les surtensions qui sont utilisés ou utilisables dans le système basse tension et qui comportent une unité d'autodiagnostic et une interface standard sans fil ou filaire présente pour la transmission de données sont aménagés pour la détermination de données de mesure de réseau au moyen de dispositifs de mesure et de contrôle de qualité d'énergie intégrés ou adaptés, une carte d'état de réseau étant établie par l'utilisation universelle et généralisée, conformément à l'usage prévu, de tels dispositifs de protection contre les surtensions aménagés, aux endroits les plus différents du réseau basse tension, et les données d'état de réseau qui en résultent en fonction du lieu et du temps étant tenues à disposition de manière à pouvoir être interrogées par l'exploitant du réseau ou le fournisseur.

2. Procédé selon la revendication 1,
**caractérisé en ce que**
la carte d'état de réseau comprend des informations concernant le spectre harmonique, des données pour l'adaptation de filtres paramétrables étant dérivées des spectres harmoniques déterminés.

3. Procédé selon la revendication 2,
**caractérisé en ce que**
au moins une partie des dispositifs de protection contre les surtensions proches du consommateur sont pourvus de filtres actifs paramétrables de sorte qu'il en résulte, dans le réseau basse tension, un système de filtrage réparti auquel des informations concernant le spectre harmonique respectif sont transmises pour ensuite améliorer la qualité du réseau par l'adaptation des filtres décentralisés.

4. Procédé selon l'une des revendications précédentes,
**caractérisé en ce que**
la transmission de données est effectuée de manière bidirectionnelle de sorte que sur la base des données de la carte d'état de réseau respectivement actuelle, des propriétés du dispositif de protection contre les surtensions quant au besoin de protection, telles que la tension de réponse, les valeurs de réglage pour la fonction de protection contre les surintensités de courant, les courants de court-circuit dans le réseau et similaires, peuvent être paramétrées de manière dynamique.

5. Procédé selon l'une des revendications précédentes,
**caractérisé en ce que**
les données de la carte d'état de réseau sont tenues à disposition par la mise à disposition sur un portail Internet et de manière à pouvoir être interrogées continuellement actualisées au moyen d'un logiciel d'application.
